# EUROPÄISCHE PATENTSCHRIFT

(11) **EP 0 632 689 B1**
(45) Veröffentlichungstag und Bekanntmachung des Hinweises auf die Patenterteilung: **04.09.1996**
(21) Anmeldenummer: 94109131.6
(22) Anmeldetag: 15.06.1994
(51) Int. Cl.: H05K 13/08, G01R 31/28

(54) **Verfahren und Anordnung zur Überprüfung von Leiterplatten**
Method and apparatus for inspection of circuit boards
Procédé et appareil pour le contrôle de plaquettes à circuit imprimé

(30) Priorität: 14.06.1993 DE 4318956
(43) Veröffentlichungstag der Anmeldung: 04.01.1995
(73) Patentinhaber: GRUNDIG E.M.V. Elektro-Mechanische Versuchsanstalt Max Grundig GmbH & Co. KG, D-90762 Fürth (DE)
(72) Erfinder: Gruber, Harald, Dipl.-Ing., Grundig E.M.V., D-90748 Fürth (DE); Eckert, Werner, Dipl.-Ing., Grundig E.M.V., D-90748 Fürth (DE); Busch, Hans-Jürgen, Dr. Ing., Grundig E.M.V., D-90748 Fürth (DE); Wagner, Hans, Dipl.-Ing., Grundig E.M.V., D-90748 Fürth (DE)

(56) Entgegenhaltungen:
- EP-A- 0 312 046
- DE-A- 3 626 061

## Beschreibung

Die Erfindung betrifft ein Verfahren und eine Anordnung zur Überprüfung von Leiterplatten, wobei die zu überprüfenden Leiterplatten mehrfach kurzzeitig beleuchtet und abgetastet werden und wobei die Überprüfung der Leiterplatten mittels der durch Abtastung erzeugten Bildsignale erfolgt.

Leiterplatten können optisch hinsichtlich Leiterbahnaufbau, Bauteilbestückung und Lötstellen überprüft werden. Dazu werden die Leiterplatten rasterförmig mittels Videokameras abgetastet, das Videosignal wird digitalisiert und in einer Bildverarbeitungseinheit ausgewertet. Hierzu ist eine Vielzahl von Verfahren bekannt.

Eine Möglichkeit ist das Differenzbildverfahren, bei dem mit einer Videokamera eine korrekte Leiterplatte aufgenommen wird. Ausgehend von dieser Aufnahme wird jeweils das Videosignal der zu testenden Leiterplatte subtrahiert. Auf diese Weise entsteht ein Differenzbild, auf dem nur die Unterschiede der beiden Bilder zu sehen sind.

Eine weitere Möglichkeit ist die Kantendetektion. Bei diesem Verfahren werden Hell/Dunkelübergänge auf Vorhandensein und korrekte Lage überprüft.

Bei einem dritten bekannten Verfahren wird die zu überprüfende Leiterplatte von schräg oben beleuchtet und der sich ergebende Schattenwurf wird in einer Bildverarbeitungseinheit ausgewertet.

Bei den bekannten Verfahren, die ein zweidimensionales, mittels einer Videokamera aufgenommenes Bild auswerten, ist jedoch während einer Bewegung der zu überprüfenden Leiterplatte eine Bildaufnahme nicht möglich. Deshalb wird die Leiterplatte in einer X-Y-Stufe gehaltert und von dieser wiederholt in einer Schrittfolgebetriebsart um eine vorgegebene Distanz versetzt. Von der Videokamera wird dann jeweils bei stillstehender X-Y-Stufe ein Bild erfaßt.

Bei einer derartigen Mustererfassung müßte die X-Y-Stufe nicht angehalten werden, falls eine stroboskopische Belichtung verwendet würde.

Aus der deutschen Patentschrift DE 36 26 061 C2 ist eine derartige Mustererfassung bekannt. Dabei wird eine stroboskopische Beleuchtung synchron zu einer vorgegebenen Geschwindigkeit durchgeführt. Dadurch werden in gleichen Abständen Bilder der zu überprüfenden Leiterplatte erfaßt.

Bei dem bekannten Verfahren ist es als nachteilig anzusehen, daß die Leiterplatten zur Mustererfassung mit einer sehr konstanten Geschwindigkeit bewegt werden müssen, weshalb die Bilderfassung mit fest vorgegebenen Abständen erfolgt. Eine Änderung der Geschwindigkeit verursacht Ungenauigkeiten beim Auffinden der abzutastenden Positionen. Dadurch wird die Überprüfung der Leiterplatten verlangsamt, da auch viele Bilder erfaßt werden, die für die Überprüfung der Leiterplatte nicht relevant sind.

Aus dem Aufsatz "Die Spreu vom Weizen trennen", von W. Schuh, erschienen in productronic 3 - 1990, S. 50 - 52, ist es bekannt, die Überprüfung nichtrelevanter Stellen der Leiterplatte zu vermeiden. Dazu werden die Koordinaten der für die Überprüfung relevanten Stellen von einem Gutmuster oder von den Daten eines CAD-Systems übernommen. Genaue Aussagen, wie die Positionierung der Kameras für die Bildaufnahmen mittels der X-Y-Stufe erfolgt, sind dem genannten Aufsatz allerdings nicht zu entnehmen.

Ausgehend von diesem Stand der Technik ist es das Ziel der vorliegenden Erfindung, ein Verfahren und eine Anordnung anzugeben, bei denen die Überprüfungsgeschwindigkeit insgesamt gesteigert wird.

Erfindungsgemäß wird diese Aufgabe durch die Merkmale der Patentansprüche 1 und 2 gelöst.

Der Vorteil der Erfindung liegt insbesondere darin, daß durch die Kombination der Vermeidung des Anhaltens der X-Y-Stufe bei der Bildaufnahme und der erhöhten, variablen Geschwindigkeit der X-Y-Stufe zwischen zwei Bildaufnahmen insgesamt eine wesentliche Steigerung der Überprüfungsgeschwindigkeit erreicht wird.

Vorteilhafte Weiterbildungen der Erfindung ergeben sich aus den Unteransprüchen und der nachfolgenden näheren Beschreibung der Erfindung mittels der Figuren.

Es zeigt:
Figur 1 ein Blockschaltbild einer erfindungsgemäßen Anordnung, und
Figur 2 ein Impulsdiagramm für das in Figur 1 dargestellte Blockschaltbild.

Für die vorliegende Erfindung wird davon ausgegangen, daß die zu überprüfenden Leiterplatten in einer gehaltert sind. Eine Videokamera wird mit einer X-Y-Verfahreinheit über die Leiterplatten geführt, um die für die Überprüfung benötigten Bildsignale zu erzeugen. Statt einer Videokamera können auch mehrere Videokameras verwendet werden, wodurch die abtastbare Bildfläche vergrößert wird. Außerdem ist statt einer Bewegung der Videokamera auch eine Bewegung der Leiterplatten möglich. Die Beleuchtung der Leiterplatten erfolgt mittels eines fest montierten Stroboskops oder einer fest montierten Blitzlampe, deren Licht durch einen oder mehrere Lichtleiter an die abzutastende Stelle geleitet wird.

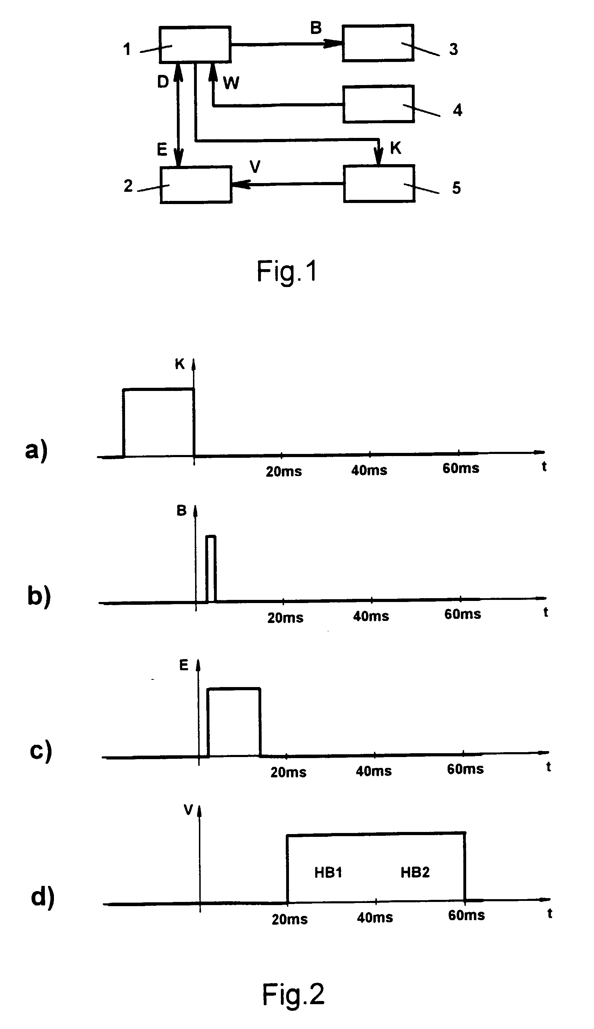

Figur 1 zeigt eine Auswerteeinrichtung 1, die eine Beleuchtungseinrichtung 3 steuert. Dazu werden die Signale W eines Wegmeßsystems 4, welches die Bewegungen der X-Y-Verfahreinheit erfaßt, und die Signale D einer Bildverarbeitungseinheit 2 ausgewertet.

Die Signale D stellen die Koordinaten der Leiterplatten dar, an denen eine Bilderfassung erfolgen soll. Diese Koordinaten werden z.B. aus der Lage der zu überprüfenden Lötstellen einer Leiterplatte gewonnen. Sie können in der Bildverarbeitungseinheit 2 aus den Konstruktionsdaten, wie sie beispielsweise aus CAD-Anlagen zur Verfügung stehen, ermittelt werden. Eine andere Möglichkeit ist es, die Koordinaten mit der CAD-Anlage zu ermitteln und in der Bildverarbeitungseinheit 2 abzuspeichern.

Wird in der Auswerteeinrichtung 1 die Übereinstimmung der durch die Signale D und W gekennzeichneten Koordinaten festgestellt, so erzeugt die Auswerteeinheit 1 einen Rücksetzimpuls K, der eine Videokamera 5 auf einen neuen Vollbildrahmen rücksetzt und ein neues Videoraster erzeugt. Bei Verwendung einer Videokamera mit CCD-Aufnahmeelement werden die Ladungszustände aller Aufnahmepunkte (Pixel) rückgesetzt.

Die von der Videokamera 5 erzeugten Videosignale V stehen an der Bildverarbeitungseinheit 2 zur Verfügung und werden, gesteuert vom Bildeinzugsignal E, in die Bildverarbeitungseinheit 2 eingelesen, wobei sie digitalisiert und anschließend für die eigentliche Überprüfung der Leiterplatte verwendet werden.

Da in der Auswerteeinrichtung 1, die beispielsweise von einem Mikrocomputer gebildet werden kann, die Koordinaten der für die Überprüfung relevanten Stellen auf den Leiterplatten bekannt sind, können die Abstände zwischen den einzelnen Aufnahmen der Videokamera 5 so gewählt werden, daß unnötige Aufnahmen entfallen. Somit ergeben sich zwischen den jeweiligen Aufnahmen unterschiedliche Abstände. Diese können mit unterschiedlichen Geschwindigkeiten der X-Y-Verfahreinheit überwunden werden. Für große Abstände kann die Geschwindigkeit größer gewählt werden als für kleine Abstände. Die jeweilige Geschwindigkeit wird von der Auswerteeinrichtung 1 bestimmt, die auch die X-Y-Verfahreinheit steuert.

Die größte zu verwendende Geschwindigkeit ist von der aufzulösenden Pixelbreite abhängig. Um Bewegungsunschärfen zu vermeiden, muß die Bewegungsgeschwindigkeit der X-Y-Verfahreinheit bei der Aufnahme und insbesondere bei der Beleuchtung mittels des Stroboskops oder der Blitzlampe so gewählt werden, daß die während der Blitzdauer zurückgelegte Strecke kleiner als eine Pixelbreite ist. Besonders gute Ergebnisse werden erzielt, wenn die während der Blitzdauer zurückgelegte Strecke etwa einem Zehntel einer Pixelbreite entspricht. Die höhere Geschwindigkeit zur Überwindung der Strecken zwischen den einzelnen Aufnahmen ergibt sich somit - bei Einhaltung der maximalen Geschwindigkeit für die Aufnahme - aus den Beschleunigungs- und Abbremseigenschaften der X-Y-Verfahreinheit sowie der zurückzulegenden Strecke.

Figur 2 stellt ein Impulsdiagramm für eine Aufnahme dar. Bereits vor Erreichen der aufzunehmenden Stelle wird der Rücksetzimpuls K für die Videokamera 5 von der Auswerteeinrichtung 1 erzeugt (Figur 2a). Daraufhin wird in der Videokamera 5 ein neuer Vollbildrahmen gestartet. Bei Erreichen der aufzunehmenden Stelle wird das Stroboskop oder der Blitz B ausgelöst (Figur 2b) und der

Impuls E zur Verarbeitung des Videosignals V durch die Bildverarbeitungseinheit 2 wird von der Auswerteeinrichtung 1 erzeugt (Figur 2c). Die im CCD-Aufnahmeelement gespeicherte Bildinformation wird gesteuert durch den Impuls E - nach Ablauf einer ersten Halbbilddauer - halbbildweise in die Bildverarbeitungseinheit 2 eingelesen (Figur 2d), wo sie ausgewertet wird.

Eine neue Positionierung der Videokamera 5 kann bereits nach Beendigung der Blitzdauer mit erhöhter Geschwindigkeit erfolgen. Ein neues Videovollbild kann beim vorliegenden Ausführungsbeispiel frühestens nach Ablauf der Dauer von drei Halbbildern erfolgen.

Zum Funktionieren der beschriebenen Erfindung ist es unbedingt erforderlich, daß jede Beleuchtung - außer der Beleuchtung durch das Stroboskop oder die Blitzlampe - vermieden wird.

## Patentansprüche

1. Verfahren zur Überprüfung von Leiterplatten mit mindestens einer elektronischen Kamera, bei dem
- die Leiterplatte zu jeder Bildaufnahme kurzzeitig beleuchtet wird,
- die Kamera bei jeder Bildaufnahme nur einen Teil der Leiterplatte erfaßt,
- zur Bildaufnahme Kamera oder Leiterplatte an vorgegebene Orte bewegt werden, wobei die vorgegebenen Orte durch zu überprüfende Strukturen auf der Leiterplatte festgelegt und bestimmt werden, und
- die von der Kamera erzeugten Bildsignale von einer nachgeschalteten Bildverarbeitungseinheit ausgewertet werden,
**dadurch gekennzeichnet**,
- daß die Bildaufnahme erfolgt, während sich Kamera und Leiterplatte mit einer Geschwindigkeit relativ zueinander bewegen, wobei die Geschwindigkeit durch die Auflösung der Kamera und die Dauer der Beleuchtung festgelegt ist, und
- daß die Bewegung von Kamera oder Leiterplatte an die vorgegebenen Orte mit einer Geschwindigkeit erfolgt, die durch die Entfernung zweier benachbarter vorgegebener Orte zueinander, die Geschwindigkeit bei der Bildaufnahme sowie die Beschleunigungs- und Abbremseigenschaften von Kamera oder Leiterplatten festgelegt ist.

2. Anordnung zur Überprüfung von Leiterplatten, mit
- mindestens einer Videokamera (5),
- einem Stroboskop oder einer Blitzlampe (3),
- einer Einrichtung zur Bewegung der Leiterplatten und der Videokamera relativ zueinander,
- einer meßeinrichtung (4) zur Messung der sich aus der relativen Bewegung ergebenden Koordinaten der Videokamera zu den Leiterplatten,
- einer Bildverarbeitungseinrichtung (2), die mittels Konstruktionsdaten die Koordinaten der zu überprüfenden Orte auf den Leiterplatten erzeugt und die Signale der Videokamera auswertet, und
- einer Auswerteeinrichtung (1), die bei Übereinstimmung der gemessenen (W) und erzeugten (D) Koordinaten die Bildaufnahme auslöst (K),
**dadurch gekennzeichnet**,
daß die Auswerteeinrichtung (1) die Einrichtung zur Bewegung so ansteuert, daß die Leiterplatten und die Videokamera (5) während der Beleuchtungsdauer des Stroboskops oder der Blitzlampe (3) relativ zueinander um eine Strecke bewegt werden, die kleiner als die Pixelbreite der Videokamera (5) ist, und
daß die Auswerteeinrichtung (1) die Einrichtung zur Bewegung so ansteuert, daß die Leiterplatten und die Videokamera (5) zwischen den einzelnen Bildaufnahmen mit einer höheren Geschwindigkeit relativ zueinander bewegt werden, wobei die Auswerteeinrichtung (1) die einzustellende Geschwindigkeit jeweils entsprechend der aus den erzeugten Koordinaten (D) bekannten Entfernungen benachbarter Orte auf den Leiterplatten zueinander, der Geschwindigkeit bei der Bildaufnahme und den Beschleunigungs- und
Abbremseigenschaften der Einrichtung zur Bewegung ermittelt.

3. Anordnung nach Anspruch 2,
**dadurch gekennzeichnet**,
daß das Stroboskop oder die Blitzlampe (3) keine relative Bewegung zu den Leiterplatten aufweist, und daß die Beleuchtung an den jeweils abzutastenden Stellen mittels eines oder mehrerer an dem Stroboskop oder der Blitzlampe angeschlossenen Lichtleiter erfolgt.

4. Anordnung nach einem der Ansprüche 2 oder 3,
**dadurch gekennzeichnet**,
daß die Videokamera (5) von der Auswerteeinrichtung (1) vor jeder Beleuchtung auf einen neuen Vollbildrahmen rückgesetzt wird.

## Claims

1. Method for inspecting printed circuit boards using at least one electronic camera, in which
- the printed circuit board is briefly illuminated for every picture record,
- the camera covers only a part of the printed circuit board in each picture record,
- for the picture record, camera or printed circuit board are moved to specified points, the specified points being set and determined by structures to be inspected on the printed circuit board, and
- the image signals generated by the camera are evaluated by a downstream image processing unit,
characterized
- in that the picture record is made while camera and printed circuit board are moving at a velocity relative to one another, the velocity being set by the resolution of the camera and the duration of the illumination, and
- in that the movement of camera or printed circuit board to the specified points takes place at a velocity which is set by the distance of two adjacent specified points from one another, the velocity during the picture record and the acceleration and deceleration properties of camera or printed circuit boards.

2. Arrangement for inspecting printed circuit boards, comprising
- at least one video camera (5),
- a stroboscope or a flashbulb (3),
- a device for moving the printed circuit boards and the video camera relative to one another,
- a measuring device (4) for measuring the coordinates, resulting from the relative movement, of the video camera with respect to the printed circuit boards,
- a picture processing device (2) which generates, by means of design data, the coordinates of the points to be inspected on the printed circuit boards and evaluates the signals of the video camera, and
- an evaluation device (1) which triggers (K) the picture record if the measured (W) and generated (D) coordinates agree,
characterized
in that the evaluation device (1) drives the movement device in such a way that the printed circuit boards and the video camera (5) are moved relative to one another during the illumination period of the stroboscope or of the flashbulb (3) by a distance which is less than the pixel width of the video camera (5), and
in that the evaluation device (1) drives the movement device in such a way that the printed circuit boards and the video camera (5) are moved relative to one another at a higher velocity between the individual picture records, the evaluation device (1) determining the velocity to be set in each case in accordance with the distances, known from the generated coordinates (D) of adjacent points from one another on the printed circuit board, the velocity during the picture record and the acceleration and deceleration properties of the movement device.

3. Arrangement according to Claim 2, characterized in that the stroboscope or the flashbulb (3) do not have any relative movement with respect to the printed circuit boards, and in that the illumination at the respective points to be scanned takes place by means of one or more optical waveguides connected to the stroboscope or the flashbulb lamp.

4. Arrangement according to one of Claims 2 or 3, characterized in that the video camera (5) is reset to a new picture frame before each illumination by the evaluation device (1).

## Revendications

1. Procédé pour contrôler des plaquettes à circuits imprimés comportant au moins un appareil de prise de vues électronique, selon lequel
- on éclaire pendant un bref intervalle de temps la plaquette à circuits imprimés pour chaque prise de vue,
- lors de chaque prise de vue, l'appareil de prise de vues détecte uniquement une partie de la plaquette à circuits imprimés,
- pour la prise de vue, on amène l'appareil de prise de vues et la plaquette à circuits imprimés en des emplacements prédéterminés, les emplacements prédéterminés étant fixés et définis par des structures à contrôler sur la plaquette à circuits imprimés, et
- les signaux d'image produits par l'appareil de prise de vues sont évalués par une unité de traitement d'images branchée en aval,
caractérisé en ce
- qu'on exécute la prise de vue alors que l'appareil de prise de vues et la plaquette à circuits imprimés se déplacent l'un par rapport à l'autre à une certaine vitesse, la vitesse étant fixée par la résolution de l'appareil de prise de vues et par la durée de l'éclairement, et
- le déplacement de l'appareil de prise de vues ou de la plaquette à circuits imprimés devant les emplacements prédéterminés s'effectue avec une vitesse qui est fixée par la distance réciproque de deux emplacements prédéterminés voisins, par la vitesse lors de la prise de vue ainsi que par les caractéristiques d'accélération et de freinage de l'appareil de prise de vues ou des plaquettes à circuits imprimés.

2. Dispositif pour contrôler des plaquettes à circuits imprimés comprenant
- au moins une caméra vidéo (5),
- un stroboscope ou une lampe flash (3),
- un dispositif pour déplacer les plaquettes à circuits imprimés et la caméra vidéo les unes par raport à l'autre,
- un dispositif de mesure (4) pour mesurer les coordonnées de la caméra vidéo, qui résultent du déplacement relatif, par rapport aux plaquettes à circuits imprimés,
- un dispositif de traitement d'image (2), qui, au moyen de données de construction, produit les coordonnées des emplacements à contrôler sur les plaquettes à circuits imprimés et évalue les signaux de la caméra vidéo, et
- un dispositif d'évaluation (1), qui déclenche (K) la prise de vue lorsqu'il y a coïncidence entre les coordonnées mesurées (W) et les coordonnées produites (D),
caractérisé en ce
que le dispositif d'évaluation (1) commande le dispositif de déplacement de telle sorte que les plaquettes à circuits imprimés et la caméra vidéo (5) sont déplacés les unes par rapport à l'autre, pendant la durée d'éclairement du stroboscope ou de la lampe flash (3), sur une distance qui est inférieure à la largeur d'un pixel de la caméra vidéo (5), et
que le dispositif d'évaluation (1) commande le dispositif de déplacement de telle sorte que les plaquettes à circuits imprimés et la caméra vidéo (5) sont déplacées les unes par rapport à l'autre entre les différentes prises de vues, avec une vitesse accrue, le dispositif d'évaluation (1) déterminant la vitesse devant être réglée, respectivement en fonction des distances les unes par rapport aux autres, connues d'après les coordonnées produites (D), d'emplacements voisins sur les plaquettes à circuits imprimés, de la vitesse lors de la prise de vue et des caractéristiques d'accélération et de freinage du dispositif de déplacement.

3. Dispositif selon la revendication 2, caractérisé en ce que le stroboscope ou la lampe flash (3) n'a aucun déplacement relatif par rapport aux plaquettes à circuits imprimés et que l'éclairement s'effectue aux emplacements devant être respectivement explorés, à l'aide d'un ou plusieurs guides de lumière raccordés au stroboscope ou à la lampe flash.

4. Dispositif selon l'une des revendications 2 ou 3, caractérisé en ce que la caméra vidéo (5) est ramenée à un nouveau cadre d'image complète par le dispositif d'évaluation (1), avant chaque éclairement.
